(19) **Europäisches Patentamt**

**European Patent Office**

**Office européen des brevets**

(11) Veröffentlichungsnummer: **0 211 277**

**A1**

(12) **EUROPÄISCHE PATENTANMELDUNG**

(21) Anmeldenummer: **86109630.3**

(22) Anmeldetag: **14.07.86**

(51) Int. Cl.⁴ **G01N 24/08**

(30) Priorität: **26.07.85 DE 3526870**

(43) Veröffentlichungstag der Anmeldung:
**25.02.87 Patentblatt 87/09**

(84) Benannte Vertragsstaaten:
**DE GB**

(71) Anmelder: **Siemens Aktiengesellschaft Berlin und München**
**Wittelsbacherplatz 2**
**D-8000 München 2(DE)**

(72) Erfinder: **Neumann, Helmut, Dipl.-Phys.**
**Steigerwaldallee 5**
**D-8520 Erlangen(DE)**

(54) **Kernspintomographiegerät.**

(57) Die Erfindung betrifft ein Kernspintomographiegerät, bei dem die Echos ($E_{11}$ usw.) in eine Meßmatrix (21) eingeordnet und aus dem so gebildeten Hologramm durch Fouriertransformation ein Bild der untersuchten Schicht berechnet wird. Die Einordnung der Echos ($E_{11}$ usw.) jeder Echosequenz ($E_1$ usw.) erfolgt in der Weise, daß zunächst die ersten Echos ($E_{11}$, $E_{21}$ usw.) jeder Echosequenz ($E_1$, $E_2$ usw.) aufeinanderfolgend wechselweise oberhalb und unterhalb der Mitte (20) der Meßmatrix (21) in Richtung zum Rand der Meßmatrix (21) hin, daran anschließend die zweiten Echos ($E_{12}$, $E_{22}$ usw.) jeder Echosequenz usw. in die Meßmatrix (21) eingeordnet werden.

FIG 3

## Kernspintomographiegerät

Die Erfindung betrifft ein Kernspintomographiegerät, bei dem Mittel zum Anlegen von magnetischen Grund-und Gradientenfeldern an das Untersuchungsobjekt und zum Erfassen der Auslenkung der Kernspins des Untersuchungsobjektes aus ihrer Gleichgewichtslage durch einen hochfrequenten magnetischen Anregungsimpuls vorhanden sind, wobei bei einer Vielzahl von Gradienten in einer Schicht des Untersuchungsobjektes jeweils eine Projektion der Kernspins auf eine Frequenzachse als Fourierzeile erfaßt, die Fourierzeilen in eine Meßmatrix eingeordnet werden und daraus ein Bild der jeweils untersuchten Schicht durch Fouriertransformation berechnet wird.

Es ist bekannt, daß man insbesondere die Wasserstoffkernspins eines Untersuchungsobjektes aus einer Vorzugsrichtung, die durch ein Magnet-Grundfeld erzeugt wird, durch einen hochfrequenten Anregungsimpuls auslenken kann und daß sich diese Spins nach dem Ende dieses Anregungsimpulses erst nach einer gewissen Zeit wieder in die Vorzugsrichtung einpendeln. Während dieser Zeit präzedieren die Spins mit einer Frequenz, die von der Stärke des MagnetGrundfeldes abhängt. Diese Präzessionsbewegung kann mit einer HF-Antenne und entsprechenden Empfängerschaltungen detektiert werden. Überlagert man diesem homogenen Magnet-Grundfeld einen ersten Feldgradienten, so daß die Magnetfeldverteilung räumlich variiert, so ist eine Ortung der Spins in einer Raumrichtung, nämlich der Gradientenrichtung, über die jeweils gemessene Frequenz möglich.

Es ist auch bekannt, daß man durch kurzzeitiges Anlegen eines zum ersten Gradienten orthogonalen zweiten Gradienten variabler Amplitude oder Zeitdauer eine Ortskodierung in einer zweiten Raumachse vornehmen kann, bevor die Signale im ersten Gradienten ausgelesen werden und auf diese Weise Schichtbilder eines Untersuchungsobjektes anfertigen kann. Die Anregung in einer Schicht des Untersuchungsobjektes erfolgt dabei dadurch, daß das MagnetGrundfeld durch einen weiteren dritten Feldgradienten senkrecht zum ersten und zweiten Gradienten so beeinflußt wird, daß nur in dieser Schicht eine Anregung der Spins erfolgt. Dies ist möglich, weil die Anregung nur mit einer Frequenz erfolgt, die dem Magnetfeld in der gewünschten Schicht streng zugeordnet ist. Dieses Verfahren ist z. B. in der DE-OS 26 11 497 beschrieben.

Der Meßvorgang kann bei einem Kernspintomographiegerät der beschriebenen Art in der Weise erfolgen, daß eine Mehrzahl von Echosequenzen ausgelesen werden, bei denen jede Echsosequenz selbst wieder aus einer bestimmten Anzahl von Echos besteht. Die einzelnen Echos müssen dann in geeigneter Weise in die Meßmatrix eingeordnet werden.

Der Erfindung liegt die Aufgabe zugrunde, die Einordnung der Echos in die Meßmatrix in der Weise zu steuern, daß bei kurzer Meßzeit ein günstiges Signal-Rausch-Verhältnis erzielt wird.

Diese Aufgabe ist erfindungsgemäß dadurch gelöst, daß eine Steuervorrichtung vorhanden ist, die die Einordnung der Fourierzeilen in die Meßmatrix in der Weise steuert, daß zunächst die ersten Echos jeder Echosequenz wechselweise oberhalb und unterhalb der Mitte der Meßmatrix in Richtung zum Rand der Meßmatrix hin, daran anschließend die zweiten Echos jeder Echosequenz usw. in die Meßmatrix eingeordnet werden. Bei dem erfindungsgemäßen Kernspintomographiegerät sind diejenigen Fourierzeilen, die viel Information für das zu erzeugende Bild beinhalten, in der Mitte der Meßmatrix und diejenigen, die weniger Information enthalten, am Rand der Meßmatrix in diese eingeordnet. Da die Mitte der Meßmatrix bei der Fouriertransformation mehr zum Bild beiträgt als der Rand, ergibt sich bei kurzer Meßzeit ein günstiges Signal-Rausch-Verhältnis.

Die Erfindung ist nachfolgend anhand eines in der Zeichnung dargestellten Ausführungsbeispieles näher erläutert. Es zeigen:

Fig. 1 eine Darstellung eines Kernspintomographiegerätes zur Erläuterung des Erfindungsgedankens, und

Fig. 2 und 3 Darstellungen zur Erläuterung der Wirkungsweise des Gerätes gemäß Figur 1.

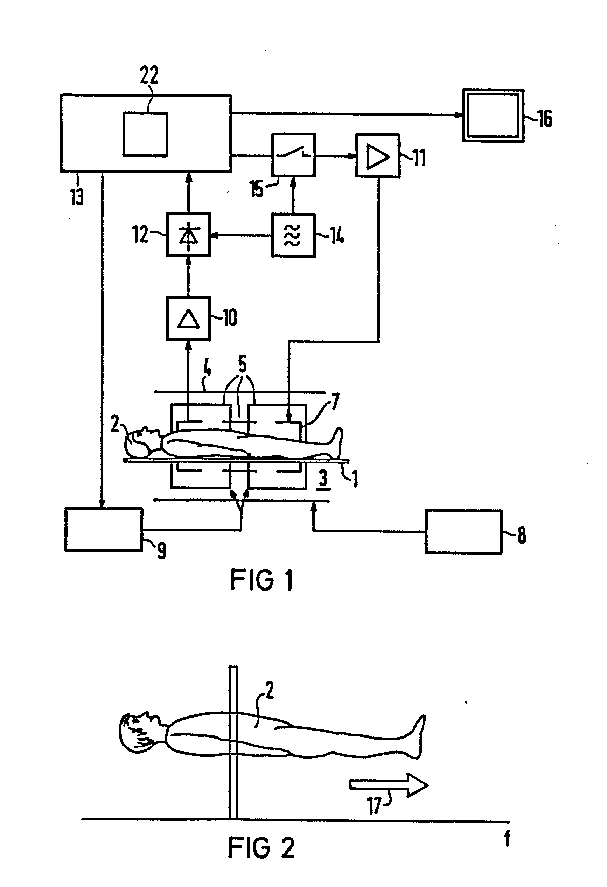

In der Figur 1 ist eine Auflage 1 dargestellt, auf der ein Patient 2 liegt, von dem mit Hilfe magnetischer Kernresonanz Bilder erzeugt werden sollen. Hierzu ist ein Spulensystem 3 mit einer Spule 4 zur Erzeugung eines homogenen Magnet-Grundfeldes, Gradientenspulen 5 zur Variierung dieses Magnet-Grundfeldes sowie mit einer Anregungs-und Meßspule 7 vorhanden. Die Spule 4 ist an einer Magnet-Stromversorgung 8, die Gradientenspulen 5 sind an einer Gradienten-Stromversorgung 9, die Anregungs-und Meßspule 7 ist an einem Vorverstärker 10 und über entsprechende Koppelelemente an einem Sendeverstärker 11 angeschlossen. Der Vorverstärker 10 führt das Meßsignal über einen phasenempfindlichen Gleichrichter 12 einem Prozeßrechner 13 zu, der den gesamten Meßvorgang steuert.

Zur Erzeugung eines Anregungsimpulses dient ein Hochfrequenzoszillator 14, der über einen Modulator 15 an den Sendeverstärker 11 anschaltbar ist. Die Wiedergabe der aus den Meßsignalen rekonstruierten Bilder erfolgt auf einem Monitor 16.

Zur Erzeugung eines Schichtbildes von dem im Spulensystem 3 gelagerten Patienten 2 werden zunächst die Spins in der gewünschten Schicht angeregt.

Die Figur 2 zeigt, daß die jeweils angeregte Schicht im Patienten 2 von der Ortsabhängigkeit der Flußdichte und damit der Kernresonanzfrequenz bestimmt wird. Der Feldgradient für das Grundfeld ist in der Figur 2 schematisch dargestellt und mit 17 bezeichnet. Die Resonanzfrequenz ist mit f bezeichnet. Es erfolgt dabei nur eine Anregung der Spins im dargestellten Bereich des Patienten 2.

Nach der Anregung erfolgt die Kodierung der Spins in der (wie oben) bezeichneten zweiten Raumachse durch Anlegen eines kurzzeitigen Gradienten in der zweiten Raumrichtung, im folgenden Kodiergradient genannt. Anschließend wird das Kernresonanzsignal in dem die erste Raumdimension definierenden sogenannten Auslesegradienten abgetastet. Dieser Vorgang wird z.B. mit - schrittweise von positiv nach negativ verändertem Kodiergradienten wiederholt. Die zu einer bestimmten Kodiergradientenamplitude ausgelesenen Kernresonanzsignale kann man als Fourierprojektion bezeichnen.

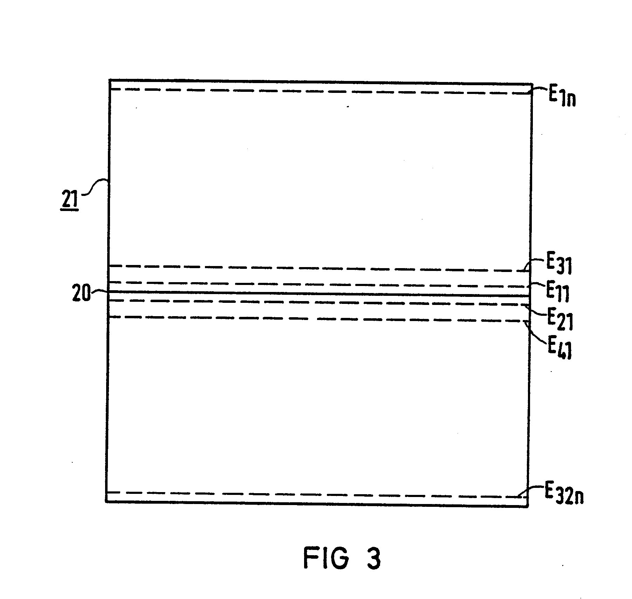

Die den aufeinanderfolgenden Fourierprojektionen entsprechenden Meßsignale entsprechen parallelen Fourierzeilen der in der Figur 3 dargestellten Meßmatrix 21. In der Praxis können beispielsweise für eine vollständige Meßmatrix 256 Fourierzeilen vorgesehen werden, wobei die Fourier-Nullzeile 20, die zum Kodiergradienten der Amplitude 0 gehört, in der Mitte der Meßmatrix 21 gemäß Figur 3 liegt. Durch zweidimensionale Fouriertransformation nach Zeilen und Spalten kann aus den Meßsignalen der einzelnen Fourierzeilen ein Bild der untersuchten Schicht berechnet werden.

Die in der Figur 3 dargestellte Meßmatrix 21 zeigt die Einordnung der Fourierzeilen nach der Erfindung. Die Einordnung wird durch eine Steuervorrichtung 22 gesteuert. Dabei ist bei dem Beispiel gemäß Figur 3 davon ausgegangen, daß beim Meßvorgang 32 mal eine Echosequenz ausgelesen wird, die mit $E_1$ bis $E_{32}$ bezeichnet wird. Jede Echosequenz $E_1$ bis $E_{32}$ besteht selbst wieder aus einer Anzahl n weiterer Echos, wobei n beispielsweise 8 ist. Demgemäß besteht die Echosequenz $E_1$ aus den Echos $E_{11}$ bis $E_{1n}$ mit n = 1, 2, ... 8, die Echosequenz $E_2$ aus den Echos $E_{21}$ bis $E_{2n}$ usw. Mit wachsendem n wird die Amplitude der Echos kleiner.

Die Steuervorrichtung 22 bewirkt nun die Einordnung der Echos in die Meßmatrix 21 gemäß Figur 3 in der Weise, daß zunächst die ersten Echos $E_{11}$, $E_{21}$, $E_{31}$, $E_{41}$ usw. jeder Echosequenz aufeinanderfolgend wechselweise oberhalb und unterhalb der Fourier-Nullzeile 20, d.h. der Mitte der Meßmatrix 21 in Richtung zum Rand der Meßmatrix 21 hin eingeordnet werden, daß daran anschließend zum Rand hin die zweiten Echos jeder Echosequenz $E_{12}$ bis $E_{32\,2}$ in die Meßmatrix eingeordnet werden usw., bis schließlich die in der Figur 3 noch dargestellten letzten Echos $E_{1n}$ und $E_{32n}$ jeder Echosequenz am Rand der Meßmatrix 21 angeordnet werden. In der Figur 3 ist nur die Einordnung der Echos $E_{11}$ bis $E_{41}$ sowie $E_{1n}$ und $E_{32n}$ dargestellt.

Durch die Einordnung der Echos der einzelnen Echosequen zen in der beschriebenen Weise wird ein Hologramm erreicht, bei dem bei kurzer Meßzeit in gutes SignalRausch-Verhältnis gegeben ist, da die mittleren Fourierzeilen die meiste Ortsinformation beinhalten und ihr Gewicht bei der Bildrekonstruktion am größten ist.

## Ansprüche

Kernspintomographiegerät, bei dem Mittel (3) zum Anlegen von magnetischen Grund-und Gradientenfeldern an das Untersuchungsobjekt (2) und zum Erfassen der Auslenkung der Kernspins des Untersuchungsobjektes (2) aus ihrer Gleichgewichtslage durch einen hochfrequenten magnetischen Anregungsimpuls vorhanden sind, wobei bei einer Vielzahl von Gradienten in der Schicht des Untersuchungsobjektes (2) jeweils eine Projektion der Kernspins auf eine Frequenzachse als Fourierzeile erfaßt, die Fourierzeilen in eine Meßmatrix - (21) eingeordnet werden und aus den Fourierzeilen ein Bild der jeweils untersuchten Schicht durch Fouriertransformation berechnet wird, **dadurch gekennzeichnet**, daß eine Steuervorrichtung (22) vorhanden ist, die die Einordnung der Fourierzeilen in die Meßmatrix (21) in der Weise steuert, daß zunächst die ersten Echos ($E_{11}$, $E_{21}$ usw.) jeder Echosequenz ($E_1$, $E_2$ usw.) aufeinanderfolgend wechselweise oberhalb und unterhalb der Mitte - (20) der Meßmatrix (21) in Richtung zum Rand der Meßmatrix (21) hin, daran anschließend die zweiten Echos ($E_{12}$, $E_{22}$ usw.) jeder Echosequenz ($E_1$, $E_2$ usw.) usw. in die Meßmatrix eingeordnet werden usw.

FIG 1

FIG 2

FIG 3

Europäisches
Patentamt

**EUROPÄISCHER RECHERCHENBERICHT**

Nummer der Anmeldung

EP    86 10 9630

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | EP-A-0 132 975  (THE REGENTS OF THE UNIVERSITY OF CALIFORNIA) <br> * Seite 11, Zeile 14 - Seite 15, Zeile 6;  Seite  40,  Zeile  1  - Seite 43, Zeile 8 * <br><br> --- | 1 | G 01 N   24/08 |
| A | US-A-4 070 611  (R.R. ERNST) <br> * Spalte 1, Zeile 20 - Spalte 2, Zeile 52;  Abbildungen  6-8  *  & DE-A-2 611 497 (Kat. A,D) <br><br> --- | 1 | |
| A,P | EP-A-0 155 052  (N.V. PHILIPS' GLOEILAMPENFABRIEKEN) <br> * Seite  4,  Zeile 24 - Seite 7, Zeile 12 * <br><br> ----- | 1 | |
| | | | **RECHERCHIERTE SACHGEBIETE (Int. Cl.4)** <br><br> G 01 N <br> H 04 N |

Der vorliegende Recherchenbericht wurde für alle Patentansprüche erstellt.

| Recherchenort | Abschlußdatum der Recherche | Prüfer |
|---|---|---|
| DEN HAAG | 04-11-1986 | HORAK G.I. |